# EUROPEAN PATENT SPECIFICATION

(11) **EP 2 660 874 B1**
(45) Date of publication and mention of the grant of the patent: **14.09.2016**
(21) Application number: 12790314.4
(22) Date of filing: 08.05.2012
(51) Int. Cl.: H01L 31/02, H01L 31/0224, H01L 31/05, H01L 31/18, H01L 31/0687

(54) **MULTI-JUNCTION COMPOUND SOLAR CELL, MULTI-JUNCTION COMPOUND SOLAR BATTERY, AND METHOD FOR MANUFACTURING SAME**
VERBUNDSOLARZELLE MIT MEHREREN ANSCHLÜSSEN, VERBUNDSOLARBATTERIE MIT MEHREREN ANSCHLÜSSEN UND HERSTELLUNGSVERFAHREN DAFÜR
CELLULE SOLAIRE COMPOSITE À MULTIPLES JONCTIONS, BATTERIE SOLAIRE COMPOSITE À MULTIPLES JONCTIONS ET PROCÉDÉ DE FABRICATION DE CELLES-CI

(30) Priority: 20.05.2011 JP 2011113643
(43) Date of publication of application: 06.11.2013
(73) Proprietor: Panasonic Intellectual Property Management Co., Ltd., Osaka 540-6207 (JP)
(72) Inventor: NOBORI, Kazuhiro, 2-1-61, Shiromi Chuo-ku Osaka 540-6207 (JP)
(74) Representative: Schwabe - Sandmair - Marx
(86) International application number: PCT/JP2012/003010
(87) International publication number: WO 2012/160765

(56) References cited:
- EP-A1- 1 953 828
- WO-A1-2010/101030
- WO-A1-2010/140371
- DE-A1-102010 012 080
- JP-A- 2000 332 287
- JP-A- 2004 319 934
- JP-A- 2008 193 089
- JP-A- 2008 529 281
- JP-A- 2010 263 217
- JP-U- H01 156 570
- JP-U- H01 156 570

## Description

### Technical Field

The claimed invention relates to a multi-junction compound solar cell, a multi-junction compound solar battery, and a method for manufacturing the same.

### Background Art

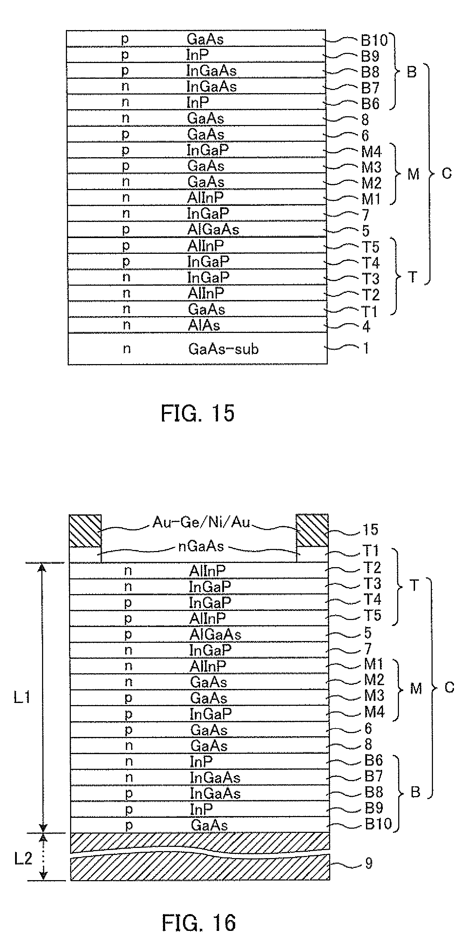

A multi-junction III-V group compound solar battery has been proposed as a solar battery suitable for a concentrating solar battery, which has the highest efficiency among solar batteries (see Patent Literature (hereinafter abbreviated as PTL) 1, for example). An example of a structure of such a multi-junction III-V group compound solar battery and a manufacturing method thereof will be described. FIG. 16 is a diagram schematically illustrating a cross-sectional structure of a multi-junction III-V group compound solar battery in the related art.

In order to obtain the multi-junction III-V group compound solar battery in the related art shown in FIG. 16, a cell laminate shown in FIG. 15 is obtained. In order to obtain the cell laminate shown in FIG. 15, first, GaAs substrate 1 is prepared as a base substrate. An AlAs layer (sacrifice layer) 4 is formed on a surface of GaAs substrate 1 by epitaxial growth, The sacrifice layer 4 is a layer to be internally broken in a final process.

Top cell T including pn junction of InGaP is formed on sacrifice layer 4. It is necessary to initially form top cell T, instead of bottom cell B, in order to match with a grating constant of the GaAs substrate and to prevent misfit dislocation or defects such as pores from occurring. Top cell T is formed by epitaxial growth of InGaP or the like. The band gap of InGaP that constitutes top cell T is about 1.7 to 2.1 eV.

Next, middle cell M including pn junction of GaAs is formed on top cell T. Middle cell M is formed by epitaxial growth of GaAs or the like. The band gap of GaAs that constitutes middle cell M is about 1.3 to 1.6 eV.

Further, bottom cell B including pn junction of InGaAs is formed on middle cell M. Bottom cell B is formed by epitaxial growth of InGaAs or the like. The band gap of InGaAs that constitutes bottom cell B is 1.0 eV or lower.

In this way, a cell laminate is obtained in which three pn junctions of InGaP, GaAs and InGaAs are connected on GaAs substrate 1 in series. The obtained cell laminate is solar cell C of a three-junction III- V group compound solar battery.

In a case where solar cell C is used as a solar battery, solar light beams are incident from the side of top cell T and proceed toward bottom cell B (InGaAs). According to this configuration, light of a predetermined wavelength based on each band gaps of top cell T, middle cell M and bottom cell B is absorbed and converted into electric energy. Thus, it is possible to realize a solar battery with high efficiency.

However, in the cell laminate in the state shown in FIG. 15, top cell T, middle cell M and bottom cell B are sequentially laminated on GaAs substrate 1. Thus, GaAs substrate 1 blocks solar light, and thus, the solar light cannot be incident on top cell T. Thus, it is difficult to use the cell laminate in the state shown in FIG. 15 as a solar battery. Hence, it is necessary to modify the above-described structure into a structure in which light can be incident from top cell T.

In order to obtain the structure in which light can be incident from top cell T, rear surface electrode 9 is formed on an overall surface of bottom cell B by plating, in a first process. In a second process, solar cell C and GaAs substrate 1 are separated from each other. The separation is performed using weakness of sacrifice layer 4. Sacrifice layer 4 that remains on the separated solar cell C is removed by etching using hydrofluoric acid.

Next, front surface electrode 15 is formed to extract an electric potential from top cell T (see FIG. 16). A metallic laminate of Au-Ge, Ni and Au is formed on an overall surface of an n-type GaAs layer (Tl) by plating, and an unnecessary portion of the metallic laminate and the GaAs layer (T1) is removed by etching, to thereby form front surface electrode 15.

Through these processes, a multi-junction compound solar battery of a double-sided electrode structure in the related art in which top cell T, middle cell M and bottom cell B are sequentially laminated and rear surface electrode 9 and front surface electrode 15 are provided, as shown in FIG. 16, is obtained.

In addition to the above-described technique, various techniques have been proposed as a technique relating to a multi-junction compound solar battery (for example, see PTLs 2 to 6).

For example, PTL 2 discloses an extraction electrode structure of a thin solar battery in which a first electrode and a second electrode are electrically connected to each other through a connecting groove provided inside a laminated band. According to this technique, it is possible to reduce the area of an extraction electrode section. However, this electrode structure is provided on the first electrode that extends from a connection terminal end portion of a plurality of solar cells that is connected in series, which does not increase the solar light receiving area of each solar cell.

For example, PTL 3 discloses a solar battery module including a plurality of solar cells in which a lower electrode (rear surface electrode) of each solar cell (tandem photoelectric conversion cell) and a transparent electrode (light receiving surface electrode) of an adjacent solar cell are electrically joined to each other through a grating electrode. According to this technique, it is possible to join the plurality of solar cells in series by the grating electrode. However, this technique does not increase the solar light receiving area of each solar cell.

### Citation List

### Patent Literature

PTL 1: Japanese Patent No. 4471584
PTL 2: Japanese Patent Application Laid-Open No. HEI 9-83001
PTL 3: Japanese Patent Application Laid-Open No. 2006-13403
PTL 4: Japanese Patent Application Laid-Open No. 2008-34592
PTL 5: US Patent Application Laid-Open No. 2011-0023962
PTL 6: US Patent Application Laid-Open No. 2010-0065115

WO 2010/140371 A1 discloses a semiconductor substrate, which is provided with: a base substrate containing silicon; an inhibiting element, which is formed on the base substrate, has an opening having the surface of the base substrate exposed therefrom, and inhibits crystal growth; and a light absorbing structure, which is formed inside of the opening by being in contact with the base substrate surface exposed inside of the opening.

### Technical Problem

As described above, the multi-junction compound solar battery in the related art includes front surface electrode 15 on the surface of top cell T. Since front surface electrode 15 is made of a metallic material such as Au, Ni or Ge that does not transmit solar light, the amount of solar light that is incident on top cell T decreases. Further, other techniques in the related art do not propose a method of increasing the solar light receiving area of a solar cell.

Due to the double-sided electrode structure of front surface electrode 15 and rear surface electrode 9, mounting of rear surface electrode 9 should be performed in a die bonding process, and mounting of front surface electrode 15 should be performed in a wire bonding process or a soldering process. That is, in order to achieve electric connection with the outside, two mounting processes of the mounting of rear surface electrode 9 and the mounting of front surface electrode 15 are necessary. As a result, a production lead time is prolonged.

Further, since the thicknesses of top cell T, middle cell M and bottom cell B that constitute solar cell C are only 5 µm to 20 µm, if stress is applied from the outside, solar cell C is easily damaged. Thus, solar cell C may be damaged due to stress generated by the process of separating solar cell C and GaAs substrate 1 using weakness of sacrifice layer 4, the die bonding process of rear surface electrode 9, the wire bonding process or the soldering process of front surface electrode 15, or the like.

In order to solve the above problems, an object of the invention is to remove an electrode that blocks solar light on top cell T of a multi-junction compound solar cell, to provide a multi-junction compound solar cell having a structure that is not easily damaged in a production process, and to reduce a production lead time of a multi-junction compound solar battery.

WO 2010/101030 A1 relates to a thin film solar cell module. Disclosed is a thin film solar cell module comprising series-connected unit cells, wherein each of the unit cells comprises a thin film silicon photoelectric conversion unit and a compound semiconductor-containing photoelectric conversion unit electrically connected to each other. Each of the unit cells comprises at least a transparent electrode, an amorphous silicon-containing photoelectric conversion unit, an intermediate transparent electrode layer, a photoelectric conversion unit, a compound semiconductor-containing photoelectric conversion unit, and a metal electrode in this order from the light incident side. In each of the unit cells, the photoelectric conversion unit and the compound semiconductor-containing photoelectric conversion unit are connected in series to form a series pass element. The series pass element is connected to a first photoelectric conversion unit in parallel via the transparent electrode and the intermediate transparent electrode layer.

EP 1 953 828 A1 relates to an inverted metamorphic solar cell with via for backside contacts. A method of forming a multijunction solar cell including an upper subcell, a middle subcell, and a lower subcell by providing a first substrate for the epitaxial growth of semiconductor material; forming a first solar subcell on the substrate having a first band gap; forming a second solar subcell over the first subcell having a second band gap smaller than the first band gap; forming a grading interlayer over the second subcell having a third band gap larger than the second band gap; forming a third solar subcell having a fourth band gap smaller than the second band gap such that the third subcell is lattice mis-matched with respect to the second subcell; and etching a via from the top of the third subcell to the substrate to enable both anode and cathode contacts to be placed on the backside of the solar cell.

### Summary of Invention

It is an object of the present invention to provide an improved and useful multi-junction compound solar cell in which the above-mentioned problems are eliminated. In order to achieve the above-mentioned object, there is provided a multi-junction compound solar cell according to claim 1. Advantageous embodiments are defined by the dependent claims.

Advantageously, there is provided a multi-junction compound solar cell including: a multi-junction cell laminate that includes a top cell and a bottom cell; a transparent electrode that is disposed on a light incident surface of the top cell; a lower electrode that has an electric potential of the bottom cell; and a side surface electrode that is disposed on a side surface of the cell laminate through an insulating layer and is conducted to the transparent electrode, wherein the side surface electrode is extended to the lower electrode.

Advantageously, an external member that is connected to each of the lower electrode and the side surface electrode, wherein conductive members that respectively connect the lower electrode and the side surface electrode with the external member include a stress absorption layer.

Advantageously, an external member that is connected to each of the lower electrode and the side surface electrode, wherein connection sections that respectively connect the lower electrode and the side surface electrode with the external member are not overlapped with the cell laminate in a pressing direction for connection of the multi-junction compound solar cell with the external member.

Advantageously, there is provided a method for manufacturing the multi-junction compound solar battery, including: pressing and joining the lower electrode and the side surface electrode of the multi-junction compound solar cell, and the external member through a conductive member, wherein the shape of a side surface of the conductive member is a tapered shape, and the tapered shape is crushed and deformed by the joining.

### Advantageous Effects of Invention

According to the multi-junction compound solar cell of the invention, since an electrode other than the transparent electrode is not provided on a solar light receiving surface, usage efficiency of solar light is enhanced. Further, according to the multi-junction compound solar cell of the invention, since the electrodes (an electrode having an electric potential of the top cell and an electrode having an electric potential of the bottom cell) connected to the outside are extended on one surface, a production process for mounting of an external electrode is performed only once. Thus, a production lead time is reduced.

Further, according to the invention, in a mounting process of the multi-junction compound solar cell to the external member, by positively deforming the stress relaxation layer disposed between the multi-junction, compound solar cell and the external member, stress applied to the solar cell is reduced. Alternatively, by regulating the positional relationship between the solar cell and the electrode connected to the outside, stress applied to the solar cell is reduced. Thus, damage of the solar cell is suppressed.

Further, by adjusting the relationship between the thickness of the solar cell and the thickness of the electrode connected to the outside, it is possible to suppress damage of the solar cell.

### Brief Description of Drawings

FIG. 1 is a cross-sectional view schematically illustrating an overall configuration of an example of a multi-junction compound solar battery according to the invention;
FIG. 2 is a cross-sectional view schematically illustrating a cell laminate in a multi-junction compound solar battery, and a solar light spectrum absorbed by each cell;
FIG. 3A is a diagram illustrating a substrate preparation process in manufacturing of a compound solar battery, FIG. 3B is a diagram illustrating an epitaxial growth process of a solar cell, FIG. 3C is a diagram illustrating a patterning process of a lower contact layer, and FIG. 3D is a diagram illustrating a patterning process of a cell laminate;
FIG. 4A is a diagram illustrating an electrode formation process in manufacturing of a compound solar battery, FIG. 4B is a diagram illustrating an insulating layer formation process, and FIG. 4C is a diagram illustrating a window opening process of an insulating layer;
FIG. 5A is a diagram illustrating an entire-surface Au/Ti film formation process for electroplating in manufacturing of a compound solar battery, FIG. 5B is a diagram illustrating a resist formation process and a side surface electrode formation process by Au plating, and FIG. 5C is a diagram illustrating a Ti film formation process for plating protection;
FIG. 6A is a diagram illustrating a resist removal process in manufacturing of a compound solar battery, and FIG. 6B is a diagram illustrating an Au/Ti film removal process on an insulating layer and a Ti film removal process on an Au plated film;
FIG. 7A is a cross-sectional view schematically illustrating an interposer substrate in which a protrusion electrode having a stress absorption layer is formed, and FIG. 7B is a diagram illustrating a junction process of an electrode of a solar cell with a protrusion electrode on an interposer substrate;
FIG. 8A is a diagram illustrating a positioning process before an electrode of a compound solar cell and a protrusion electrode on an interposer substrate are joined to each other, and FIG. 8B is a process diagram illustrating a state where an electrode of a solar cell and a protrusion electrode on an interposer substrate are joined to each other;
FIG. 9A is a diagram illustrating, in a state where an electrode of a compound solar cell and a protrusion electrode on an interposer substrate are joined to each other, the positional relationship between the electrode on the solar cell and the protrusion electrode, and FIG. 9B is a diagram illustrating the dimension relationship of respective members in a solar cell;
FIG. 10A is a top view illustrating, in a state where an electrode of a compound solar cell and a protrusion electrode on an interposer substrate are joined to each other, the positional relationship between the solar cell and the protrusion electrode, and FIG. 10B is a side sectional view thereof;
FIG. 11A is a diagram illustrating a sealing resin filling process in manufacturing of a compound solar battery, and FIG. 11B is a diagram illustrating a formation process of concave portion in a sacrifice layer as a starting point for separating an GaAs substrate by a sacrifice layer;
FIG. 12A is a diagram illustrating a separation process of a GaAs substrate from a compound solar cell in manufacturing of a compound solar battery, and FIG. 12B is a diagram illustrating an etching removal process of a remaining sacrifice layer by hydrofluoric acid;
FIG. 13A is a diagram illustrating a transparent electrode formation process in manufacturing of a compound solar battery, and FIG. 13B is a diagram illustrating a division process of a solar cell and an interposer substrate into a regulated size;
FIG. 14A is a diagram illustrating a process of irradiating ultraviolet rays (UV) onto an electron sheet and extracting divided solar batteries from the electron sheet by a pickup head, in manufacturing of a compound solar battery, and FIG. 14B is a diagram illustrating an individualized package form;
FIG. 15 is a cross-sectional view schematically illustrating a compound solar battery; and
FIG. 16 is a cross-sectional view schematically illustrating a compound solar battery in the related art.

### Description of Embodiments

Hereinafter, a compound solar battery according to an embodiment of the invention will be described with reference to the accompanying drawings. The same reference numerals are given to substantially the same members in the drawings, and description thereof will be omitted.

### <Overall configuration of compound solar battery>

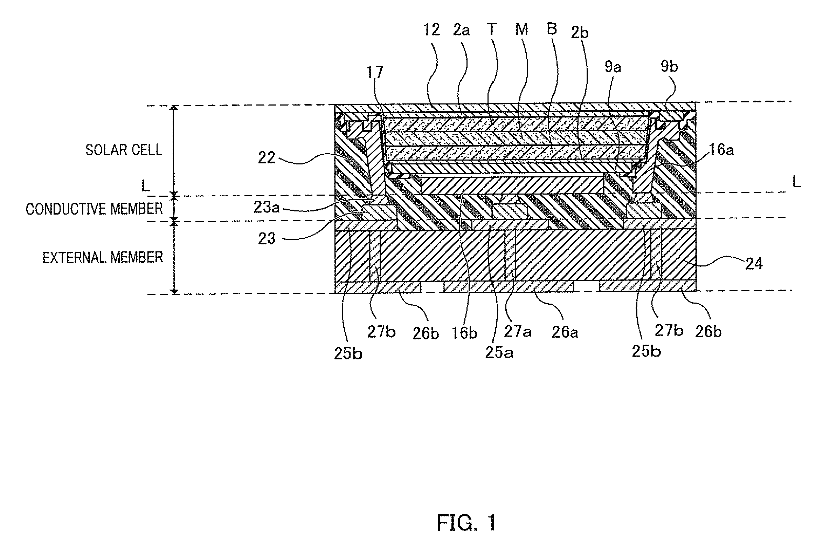

FIG. 1 is a cross-sectional view schematically illustrating an overall configuration of a compound solar battery according to an embodiment of the invention. As shown in FIG. 1, the compound solar battery according to the embodiment includes 1) multi-junction compound solar cell 10, 2) interposer substrate 24 that is an external member, and 3) a conductive member that electrically connects compound solar cell 10 and interposer substrate 24,

Solar cell 10 of the multi-junction compound solar battery shown in FIG. 1 includes a cell laminate having a three-layer structure of top cell T, middle cell M and bottom cell B. A PN junction layer is present in each of three layers of the cell laminate. The cell laminate includes upper contact layer 2a provided on an upper surface of top cell T, and lower contact layer 2b provided on a lower surface of bottom cell B.

Solar cell 10 includes transparent electrode (ZnO) 12 provided on an upper surface of upper contact layer 2a of the cell laminate. Transparent electrode 12 extracts an electric potential of top cell T. Upper electrode 9b is connected to transparent electrode 12. Side surface electrode 16a is connected to upper electrode 9b. Insulating layer 17 is present between side surface electrode 16a and the cell laminate to insulate side surface electrode 16a from the cell laminate. Insulating layer 17 is composed of a silicon nitride film or the like.

On the other hand, solar cell 10 includes lower electrode 9a provided on a lower surface of lower contact layer 2b of the cell laminate. Central electrode 16b is provided on a lower surface of lower electrode 9a.

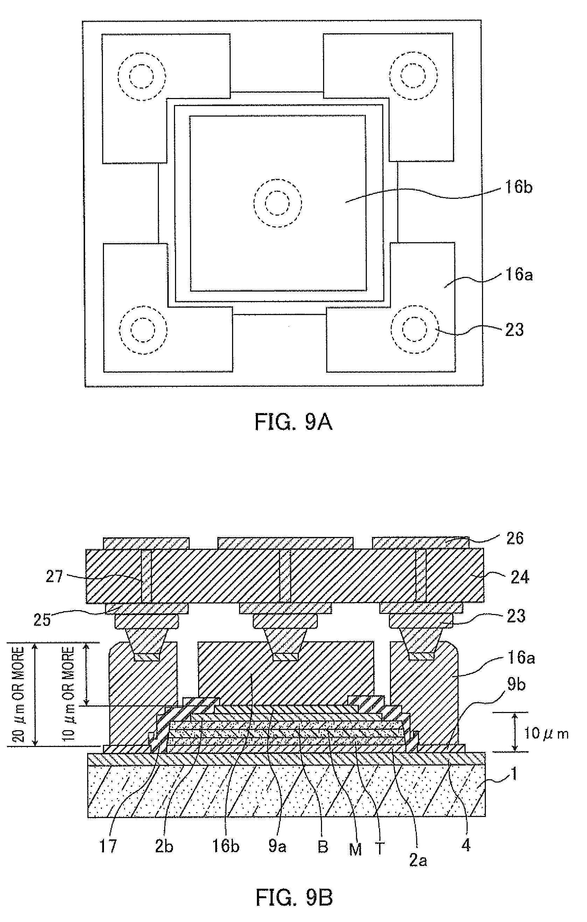

Here, it is preferable that a lower surface of side surface electrode 16a and a lower surface of central electrode 16b are aligned with each other on a broken line LL. When interposer substrate 24 joins with solar cell 10 which will be described later referring to FIGS. 9A and 9B, pressure is uniformly applied to solar cell 10, and thus, it is possible to prevent solar cell 10 from being damaged. In this way, side surface electrode 16a having an electric potential generated by top cell T and central electrode 16b having an electric potential generated by bottom cell B are arranged on the same plane.

The lower surface of side surface electrode 16a and the lower surface of central electrode 16b that are arranged on the same plane are electrically connected to element-sided electrodes 25a and 25b of interposer substrate 24 that is the external member through a conductive member, respectively. Side surface electrode 16a and central electrode 16b are electrically arranged independently of each other. Similarly, element-sided electrode 25a and element-sided electrode 25b, through electrode 27a and through electrode 27b, and external extraction electrode 26a and external extraction electrode 26b are electrically arranged independently of each other.

Interposer substrate 24 includes element-sided electrode 25 that is arranged on an upper surface thereof (surface that faces solar cell 10), external extraction electrode 26 that is arranged on a lower surface thereof, and through electrode 27 that passes through the inside of interposer substrate 24 to connect element-sided electrode 25 with external extraction electrode 26.

The conductive member includes protrusion electrode 23 having stress absorption layer 23a. Protrusion electrode 23 is connected to element-sided electrode 25 of interposer substrate 24.

A gap between interposer substrate 24 and solar cell 10 is sealed by sealing resin 22 in order to reinforce mechanical strength and to improve chemical resistance. In this way, an overall configuration of a single multi-junction compound solar battery is achieved as a package.

### <Cell laminate>

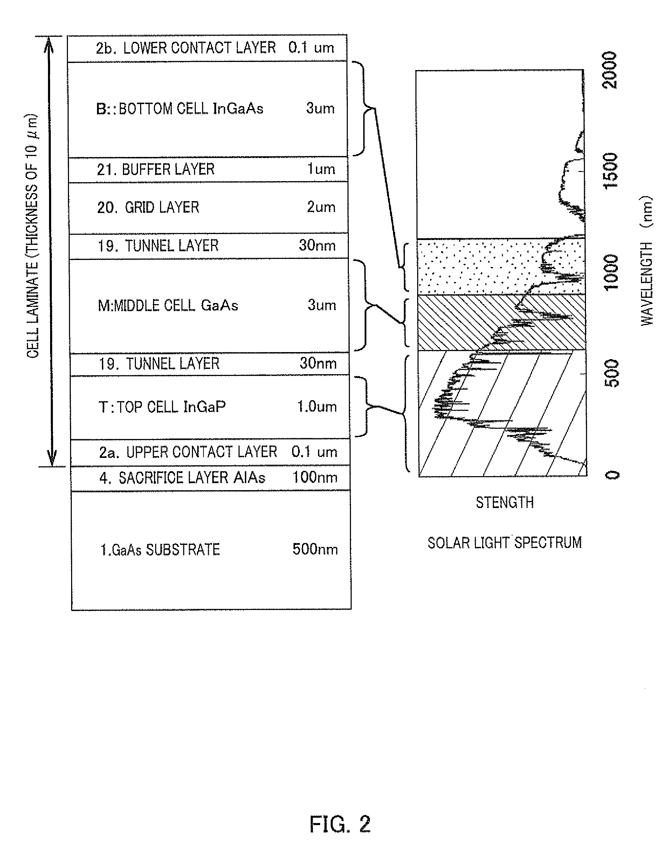

FIG. 2 shows a cell laminate of the solar battery shown in FIG. 1. As described above, the cell laminate includes upper contact layer 2a, top cell T, middle cell M, bottom cell B, and lower contact layer 2b. The cell laminate is obtained by forming the respective metallic layers on GaAs substrate 1. Each metallic layer cab be formed by an epitaxial growth method in a longitudinal MOCVD (Metal Organic Chemical Vapor Deposition) apparatus.

The epitaxial growth of each metallic layer may be performed by a normal technique. For example, an environment temperature may be set to about 700°C. TMG (trimethylgallium) and AsH3 (arshin) may be used as a material for growth of the GaAs layer. TMI (trimethylindium), TMG and PH3 (phosphine) may be used as a material for growth of an InGaP layer. Further, SiH₄ (monosilane) may be used as an impurity for formation of an n-type GaAs layer, an n-type InGaP layer and an n-type InGaAs layer. On the other hand, DEZn (diethyl zinc) may be used as an impurity for formation of a p-type GaAs layer, a p-type InGaP layer and a p-type InGaAs layer.

First, an AlAs layer having a thickness of about 100 nm is grown on GaAs substrate 1 as sacrifice layer 4. Then, an n-type InGaP layer having a thickness of about 0.1 µm is grown as upper contact layer 2a.

Next, top cell T is formed. An n-type InAlP layer having a thickness of about 25 nm that is a window, an n-type InGaP layer having a thickness of about 0.1 µm that is an emitter, a p-type InGaP layer having a thickness of about 0.9 µm that is a base, and a p-type InGaP layer having a thickness of about 0.1 µm that is a BSF are respectively formed by the epitaxial growth method. As a result, top cell T having a thickness of about 1 µm is formed.

After top cell T is formed, a p-type AlGaAs layer having a thickness of about 12 nm and an n-type GaAs layer having a thickness of about 20 nm are grown as tunnel layer 19. As a result, tunnel layer 19 having a thickness of about 30 nm is formed.

Then, middle cell M is formed. An n-type InGaP layer having a thickness of about 0.1 µm that is a window, an n-type GaAs layer having a thickness of about 0.1 µm that is an emitter, a p-type GaAs layer having a thickness of about 2.5 µm that is a base, and a p-type InGaP layer having a thickness of about 50 nm that is a BSF are respectively formed by the epitaxial growth method. As a result, middle cell M having a thickness of about 3 µm is formed.

After middle cell M is formed, a p-type AlGaAs layer having a thickness of about 12 nm and an n-type GaAs layer having a thickness of about 20 nm are grown as tunnel layer 19. As a result, tunnel layer 19 having a thickness of about 30 nm is formed.

Next, grid layer 20 is formed. Grid layer 20 suppresses occurrence of dislocation, defects or the like due to mismatch of grating constants. An n-type InGaP layer having a thickness of about 0.25 µm is provided to form eight layers, and grid layer 20 having a thickness of about 2 µm is formed. Further, an n-type InGaP layer having a thickness of about 1 µm is formed as buffer layer 21.

Next, bottom cell B is formed. An n-type InGaP layer having a thickness of about 50 nm that is a passivation film, an n-type InGaAs layer having a thickness of about 0.1 µm that is an emitter, a p-type InGaAs layer having a thickness of about 2.9 µm that is a base, and a p-type InGaP layer having a thickness of about 50 nm that is a passivation film are respectively formed by the epitaxial growth method. As a result, bottom cell B having a thickness of about 3 µm is formed. Finally, a p-type InGaAs layer having a thickness of about 0.1 µm is formed as lower contact layer 2b.

FIG. 2 shows wavelengths of light absorbed by top cell T, middle cell M and bottom cell B. The band gap of top cell T is 1.87 eV, in which a wavelength capable of being absorbed in a solar light spectrum is in the range of 650 nm or less. The band gap of middle cell M is 1.41 eV, in which a wavelength capable of being absorbed in the solar light spectrum is in the range of 650 nm to 900 nm. The band gap of bottom cell B is 1.0 eV, in which a wavelength capable of being absorbed in the solar light spectrum is in the range of 900 nm to 1200 mn. In this way, by configuring the cell laminate of the solar cell as the three-layer structure of top cell T, middle cell M and bottom cell B, it is possible to effectively use the solar light spectrum. Thus, it is possible to realize a solar battery with high efficiency.

### <Manufacturing method and structure of f compound solar battery>

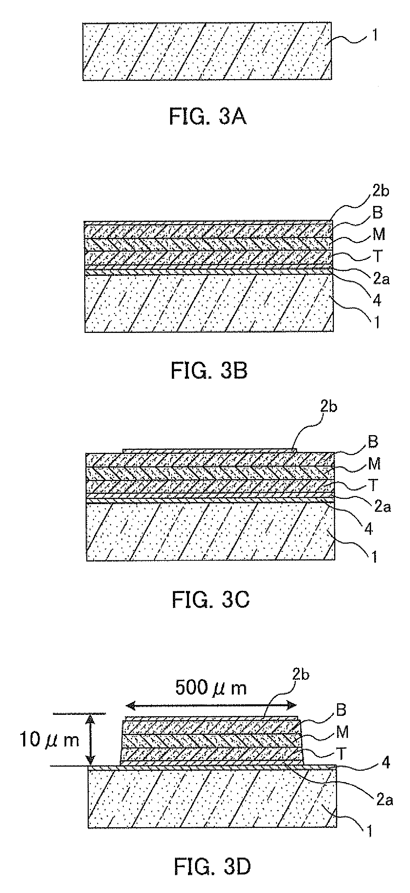

The manufacturing flow of the compound solar battery will be described with reference to FIGS. 3A to 3D, FIGS. 4A to 4C, FIGS. 5A to 5C, FIGS. 6A and 6B, and FIGS. 7A and 7B. In a process of FIG. 3A, GaAs substrate 1 (wafer) is prepared. The size of GaAs substrate 1 is a 4-inch diameter and a thickness of 500 µm, for example. Normally, a plurality of solar cells 10 is formed on one GaAs substrate 1.

In a process of FIG. 3B, the cell laminate (see FIG. 2) is formed on GaAs substrate 1. The cell laminate is obtained by the epitaxial growth of sacrifice layer 4, upper contact layer 2a, top cell T, middle cell M, bottom cell B, lower contact layer 2b, and the like.

In a process of FIG. 3C, lower contact layer 2b having a thickness of about 0.1 µm is patterned in a predetermined size. It is preferable to perform the patterning through a dry etching process.

In a process of FIG. 3D, the cell laminate having a thickness of 10 µm is patterned in a predetermined size. It is preferable to perform the patterning through a dry etching process. It is confirmed that as the cell laminate is arranged inside edges of GaAs substrate 1, loss of carriers generated around a solar battery portion is suppressed and conversion efficiency is improved. In this way, a structure in which the cell laminate is etched in its edge portions may be referred to as a "ledge structure." As disclosed in "J. Vac. Sci. Technol. B, Vol, 11, No. 1, Jan/Feb 1993", "IEICE Technical Report ED2007-217, MW2007-148 (2008-1)" or the like, it is known that loss of carriers easily occurs in an end portion of PN junction. On the other hand, by employing the "ledge structure'', carriers are collected inside the substrate, to thereby suppress carrier loss in the end portion.

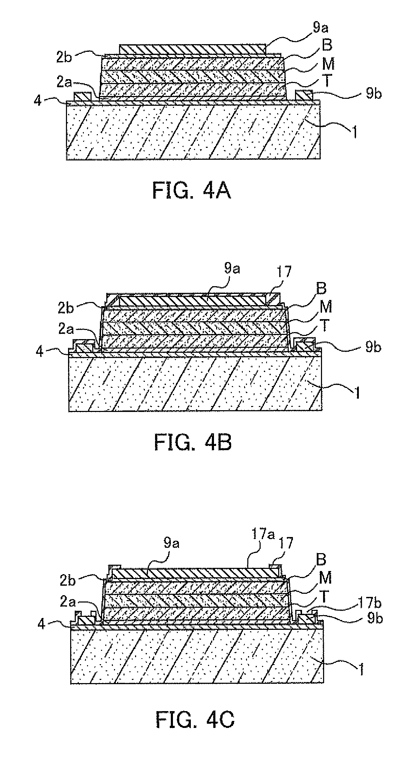

In a process of FIG. 4A, an Au plating electrode is formed as upper electrode 9b and lower electrode 9a. First, an Au plated film having a thickness of about 10 µm or less is formed on an overall upper surface of the cell laminate shown in FIG. 3D by an electric field plating method. The Au plated film is patterned to form upper electrode 9b and lower electrode 9a. The patterning may be performed by a photolithography method and a wet etching process.

In a process of FIG. 4B, an SiN film is formed as insulating layer 17. For example, the SiN film is formed on the overall upper surface of the cell laminate using a plasma CVD method, for example.

In a process of FIG. 4C, an unnecessary portion of insulating layer 17 is removed to form windows 17a and 17b of insulating layer 17. Windows 17a and 17b of insulating layer 17 expose Au plating surfaces that constitute lower electrode 9a and upper electrode 9b, respectively.

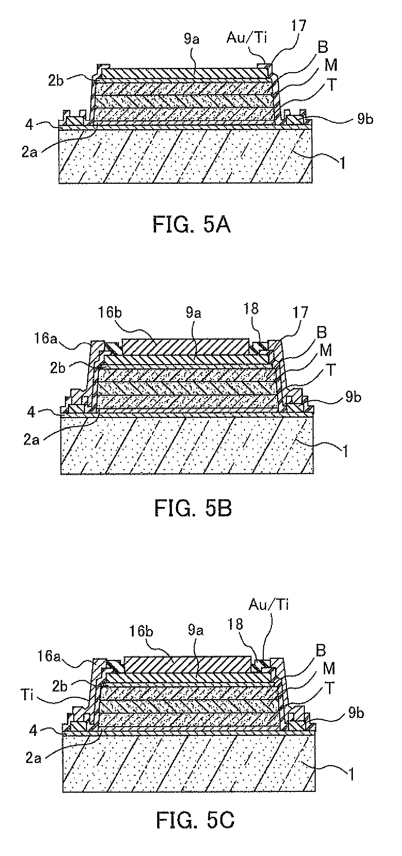

In a process of FIG. 5A, an Au/Ti laminated film is formed on the overall upper surface of the cell laminate obtained in FIG. 4C using a metal sputtering method. The Au/Ti laminated film is for a pre-processing film for performing electrolytic Au plating in the next process.

In a process of FIG. 5B, resist 18 is formed in a portion where it is not necessary to form an electrolytic Au plated film, and then, the electrolytic Au plated film is formed. Resist 18 is formed by forming a predetermined resist pattern for mesa etching and by etching an unnecessary portion by an alkali aqueous solution or an acid solution through an exposure process.

Central electrode 16b and side surface electrode 16a are formed by electrolytic Au plating. The thicknesses of central electrode 16b and side surface electrode 16a made of the Au plated film can be larger than 10 µm that corresponds to a thickness of the cell laminate of the solar cell, which is about 10 µm to about 50 µm.

In a process of FIG. 5C, a Ti film for protection of the Au plated film is formed. The Ti film may be formed by a metal sputtering process, and is formed on the overall upper surface of the laminate obtained in FIG. 5B.

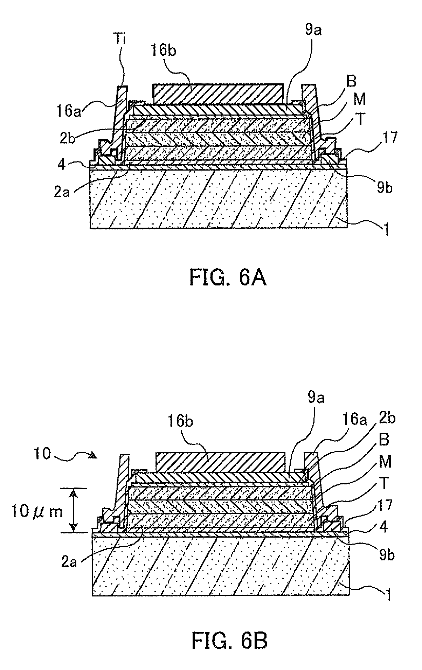

In a process of FIG. 6A, resist 18 is removed. Removal of resist 18 is performed by a wet process. It is possible to remove only resist 18 by etching using an alkali aqueous solution or an acid solution.

In a process of FIG. 6B, the Au/Ti film on insulating layer 17 and the Ti film on the An plated electrode are removed. The removal is performed by a dry edge process. In this way, the outermost surface of the Au plated electrode is provided as a clean surface without organic contamination.

As shown in FIG. 6B, a platform of a multi-junction compound solar cell of a single-sided junction is obtained. However, in the multi-junction compound solar cell of the single-sided junction shown in FIG. 6B, top cell T is disposed on the side of GaAs substrate 1, and bottom cell B is disposed on the side of central electrode 16b. In order to obtain a solar battery using this structure, solar light should be allowed to be input from top cell T. Accordingly, GaAs substrate 1 should be separated without causing damage to solar cell 10.

One characteristic of the invention is that GaAs substrate 1 is separated to obtain a solar battery without causing damage to the cell laminate, in spite of a reduced thickness (for example, 10 µm or less) of the cell laminate of solar cell 10.

### <Interposer substrate>

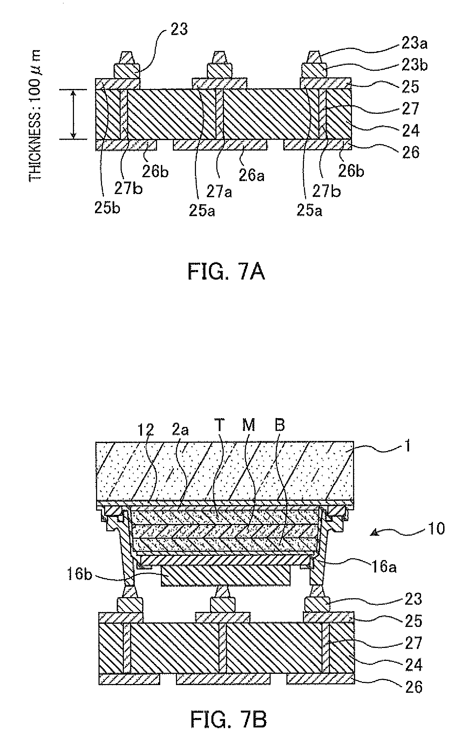

FIG. 7A shows interposer substrate 24. The size of interposer substrate 24 is 20 mm x 20 mm, or a 4-inch diameter (the same as in substrate 1). Further, the thickness of interposer substrate 24 is 100 µm.

Interposer substrate 24 can be composed of silicon, ceramic, glass epoxy, glass or the like, and includes through electrode 27 passing through the inside thereof. Further, interposer substrate 24 includes element-sided electrode 25 on a surface thereof where solar cell 10 is to be arranged, and external extraction electrode 26 on an opposite surface thereof. The outermost surfaces of element-sided electrode 25 and external extraction electrode 26 are covered by an Au film. The Au film is formed by flash Au plating or electrolytic Au plating, and has a maximum thickness of 0.5 µm.

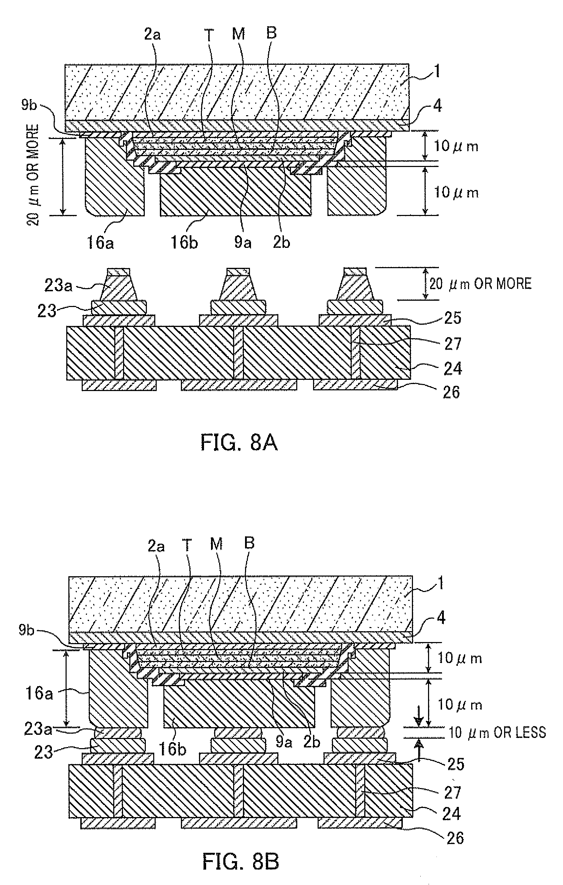

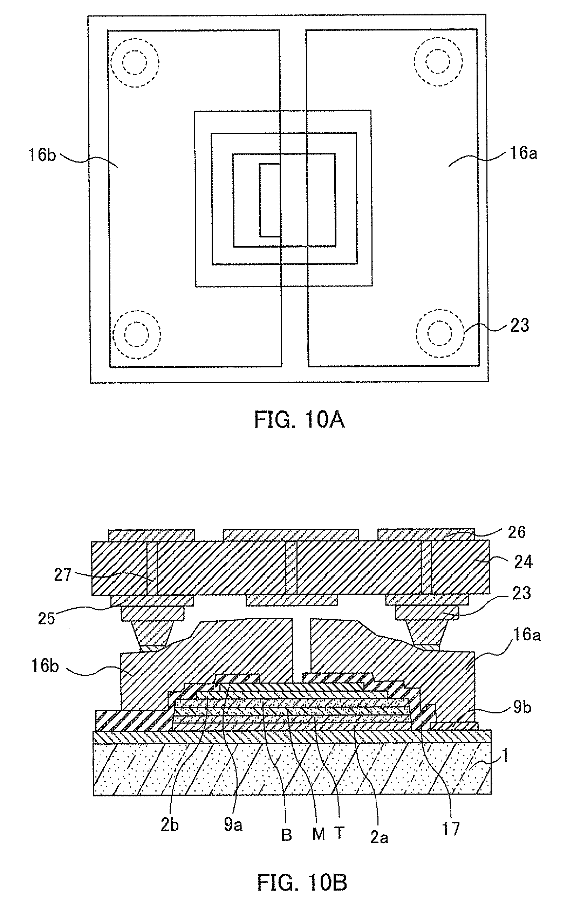

In a process of FIG. 7B, interposer substrate 24 (see FIG. 7A) and solar cell 10 (see FIG. 6B) to which GaAs substrate 1 is attached are joined to each other. Specifically, protrusion electrodes 23 of interposer substrate 24 are joined to central electrode 16b and side surface electrode 16a of solar cell 10, respectively. Stress generated in this junction is not to be applied to the cell laminate of the solar cell 10, which is another characteristic of the invention. As examples of a method of preventing stress from being applied to the cell laminate of solar cell 10, there are 1) a method of arranging a stress absorption layer on protrusion electrode 23 (see FIGS. 7A and 7B and FIGS. 8A and 8B), 2) a method of forming protrusion electrode 23 composed of conductive paste or a flexible material, 3) a method of forming central electrode 16b and side surface electrode 16a composed of a flexible material (see FIGS. 9A and 9B), and 4) a method of displacing a connection section of protrusion electrodes 23 with central electrode 16b and side surface electrode 16a of solar cell 10 from the cell laminate of solar cell 10 (see FIGS. 10A and 10B). Hereinafter, the respective methods will be described.

### <Stress absorption layer>

As shown in FIG. 7A, protrusion electrode 23 is arranged on element-sided electrode 25 of interposer substrate 24. Here, protrusion electrode 23 includes stress absorption layer 23a and column portion 23b. Stress absorption layer 23a is formed in a conical shape so that its side surface has a tapered structure. Column portion 23b is formed in a cylindrical shape. Specifically, the side surface of stress absorption layer 23a is inclined at 30° to 60° with respect to a vertical direction in FIG. 7A. Further, the cross-sectional area of column portion 23b (cross-sectional area of a surface orthogonal to the vertical direction in FIG. 7A) is smaller than the cross-sectional area of stress absorption layer 23a.

The material of protrusion electrode 23 is generally Au, but may be a single metal such as Ti, Cu, Al, Sn, Ag, Pd, Bi, Pb, Ni or Cr, or may be a composite metal thereof. Protrusion electrode 23 made of a metallic material may be formed by a technique such as a stud bump method using a wire bonding process. For example, the diameter of column portion 23b is set to 20 µm to 50 µm, and the thickness of column portion 23b (length in a conducting direction) is set to 6 µm to 10 µm, and the thickness of the stress absorption layer is set to 20 µm or more.

In this way, protrusion electrode 23 is composed of two conductive members (column portion 23b and stress absorption layer 23a) having different shapes. Further, the cross-section of stress absorption layer 23a connected to solar cell 10 is set to be smaller than the cross-section of column portion 23b. Stress absorption layer 23a is deformed due to stress applied when solar cell 10 and interposer substrate 24 are joined to each other to relieve stress (see FIG. 8B). A conical tip end of stress absorption layer 23a after deformation is in the state of being crushed flat (see FIG. 8B).

In a process of FIG. 8A, protrusion electrodes 23 of interposer substrate 24 are aligned in position with central electrode 16b and side surface electrode 16a of solar cell 10. The thickness of the cell laminate of solar cell 10 is thin (for example, 10 µm or less) and weak, and is thus easily damaged. Thus, it is preferable that the thickness of central electrode 16b formed in solar cell 10 be set to be larger than the thickness of the cell laminate of solar cell 10 (for example, set to 10 µm or more). Further, it is preferable that the thickness of stress absorption layer 23a of protrusion electrode 23 be set to be 20 µm or more.

In a process of FIG. 8B, central electrode 16b and side surface electrode 16a of solar cell 10 are metal-joined to stress absorption layers 23a a of protrusion electrodes 23 via Au/Au bonding. The metal joining may be performed while applying ultrasonic energy under the temperature condition of 150°C to 250°C. In the Au/Au metal joining, tapered stress absorption layer 23a is deformed and crushed. Stress absorption layer 23a may be deformed and crushed by 10 µm or more, which is a thickness of solar battery element 10. The thickness of the stress absorption layer after deformation is set to 10 µ**m** or less. If the deformable amount of the stress absorption layer is larger than the thickness of solar battery element 10, excessive stress applied to solar cell 10 is reduced.

Further, column portion 23b and stress absorption layer 23a of protrusion electrode 23 may be composed of metals having different Young's modulus. Specifically, column portion 23b is composed of a metal having a high Young's modulus, and stress absorption layer 23a is composed of a metal having a low Young's modulus. Two metallic materials are selected from Au, Al, Cu, Ag, Sn, Bi or the like, respectively.

Junctions of central electrode 16b and side surface electrode 16a of solar cell 10 with protrusion electrodes 23 are performed by ultrasonic metal junction using a heating ultrasonic head, for example. In a case where the ultrasonic metal junction is performed, surfaces of side surface electrode 16a and central electrode 16b are formed by Au, Al, Cu, Ag, Sn or the like. The ultrasonic metal junction is a junction method of breaking oxide films of the metal surfaces with heating and ultrasonic energy so as to for an alloy layer between metals.

In this way, by arranging stress absorption layer 23a that is in contact with solar cell 10 composed of a metal having a low Young's modulus, upon preforming junction, the stress absorption layer is easily deformed, and thus, stress is further easily relieved.

### <Protrusion electrode formed of conductive paste or the like>

Protrusion electrode 23 that is arranged over interposer substrate 24 may be formed of conductive paste. The conductive paste includes a resin component such as epoxy resin or silicone resin, and a conductive metal such as Ag, Pd, Au, Cu, Al, Ni, Cr or Ti. Protrusion electrode 23 that is composed of the conductive paste may be formed by a coating method or a printing method. Protrusion electrode 23 that is composed of the conductive paste may not include stress absorption layer 23a, that is, do not necessarily have a tapered shape. Solar cell 10 is in contact with the conductive paste that constitutes protrusion electrode 23, and then cures the conductive paste. Thus, excessive stress is not applied to solar cell 10.

In order to join central electrode 16b and side surface electrode 16a of solar cell 10 with the protrusion electrode formed of the conductive paste, central electrode 16b and side surface electrode 16a of solar cell 10 may be in contact with protrusion electrode 23 to cure the conductive paste contained in protrusion electrode 23.

Protrusion electrode 23 may be formed of a flexible material (conductive resin or the like). Protrusion electrode 23 composed of the conductive resin may be formed by dispenser coating or mask printing. It is preferable that the viscosity of the conductive resin be 2000 cps to 500000 cps. The conductive resin is a liquid resin including metallic fillers made of Ag, Pd, Au, Cu or the like.

If central electrode 16b and side surface electrode 16a of solar cell 10 are joined to protrusion electrode 23 composed of the flexible material, stress applied to solar cell 10 may be absorbed by protrusion electrode 23.

### <Central electrode and side surface electrode formed of flexible material>

FIGS. 9A and 9B show an example in which central electrode 16b and side surface electrode 16a of solar cell 10 are formed of a flexible material. As shown in FIG. 9A, side surface electrode 16a and central electrode 16b are arranged to be electrically independent of each other. In this case, stress absorption layer 23a is not necessary, and protrusion electrode 23 may be formed of a hard material. In this case, protrusion electrodes 23 are not deformed and are inserted into central electrode 16b and side surface electrode 16a. Thus, it is preferable to increase the thicknesses of central electrode 16b and side surface electrode 16a of solar cell 10 to prevent solar cell 10 from being damaged. For example, in a case where the thickness of the cell laminate of solar cell 10 is 10 µm, the thicknesses of central electrode 16b and side surface electrode 16a are set to 10 µm or more, and the amount of insertion of the protrusion electrode is set to 10 µm or less.

Central electrode 16b and side surface electrode 16a shown in FIGS. 8A and 8B and FIGS. 9A and 9B, and central electrode 16b and side surface electrode 16a shown in FIG. 1 or the like have different dimension relationships or ratios. As described above, this shows that the thicknesses of central electrode 16b and side surface electrode 16a are set to be thick in view of prevention of damage to solar cell 10. Accordingly, members having the same reference numerals have the same basic functions.

### connection section of central electrodes with side surface electrode and protrusion electrode>

FIGS. 10A and 10B show an example in which the connection positions of central electrode 16b and side surface electrode 16a of solar cell 10 with protrusion electrodes 23 displace from of the cell laminate of solar cell 10. That is, the connection positions of central electrode 16b and side surface electrode 16a with protrusion electrode 23 are not overlapped with the cell laminate in a direction where a force for joining solar cell 10 and interposer substrate 24 is applied.

The solar cell shown in FIG. 10B is different from the solar cell shown in FIG. 6B in the structure of central electrode 16b. Central electrode 16b that is connected to bottom cell B of the solar cell shown in FIG. 10B is extended to a peripheral portion from the central portion of solar cell 10. The peripheral portion of the solar cell is not overlapped with the cell laminate. Central electrode 16b that is extended to the peripheral portion is joined to protrusion electrode 23. Thus, upon junction of solar cell 10 with interposer substrate 24, a stress is prevented from being applied to the cell laminate of solar cell 10.

### <reinforcement due to sealing resin>

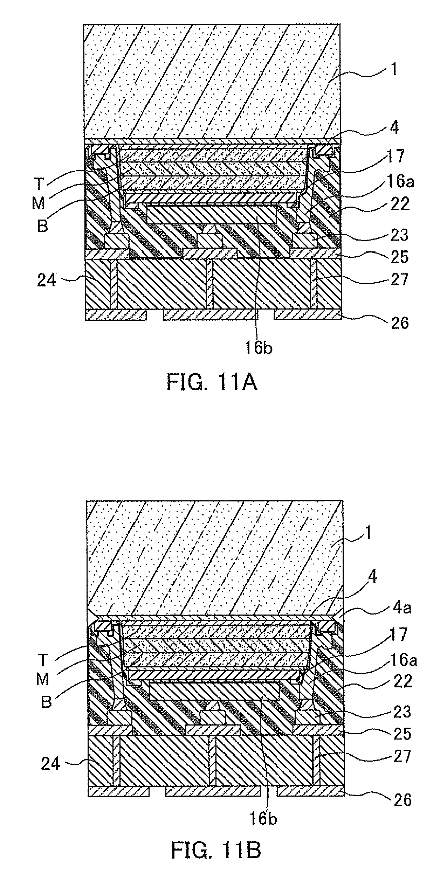

As described above, after interposer substrate 24 (see FIG. 7A) and solar cell 10 (see FIG. 6B) to which GaAs substrate 1 is attached are joined to each other, in a process of FIG. 11A, a gap between interposer substrate 24 and solar cell 10 is filled with resin. By filling the above-mentioned gap with sealing resin 22, the strength of the package is retained, and chemical resistance is improved. Normally, sealing resin 22 is an epoxy resin or a silicone resin.

As described above, the size of GaAs substrate 1 is a 4-inch diameter, and the size of interposer substrate 24 is 20 mm x 20 mm or a 4-inch diameter. In a case where the size of interposer substrate 24 is a square of 20 mm x 20 mm, a plurality of interposer substrates is mounted on GaAs substrate 1 that is a 4-inch wafer. Sealing resin 22 is flow from a gap between the plurality of interposer substrates to a gap between GaAs substrate 1 and interposer substrate 24 using the capillary phenomenon. As a result the gaps are filled with the sealing resin 22.

On the other hand, in a case where interposer substrate 24 is the 4-inch diameter, similarly, the gaps are filled with sealing resin 22 using the capillary phenomenon. In this case, it is preferable to employ sealing resin 22 with a low viscosity.

After the gap between GaAs substrate 1 and interposer substrate 24 is filled with sealing resin 22, sealing resin 22 is heated at about 150°C to 200°C for about 15 minutes to about 1 hour to be cured.

### <Formation of sacrifice layer concave portion>

In a process of FIG. 11B, in order to separate GaAs substrate 1, sacrifice layer concave portion 4a is formed on a side surface of sacrifice layer 4. Since solar cell 10 is very weak, solar cell 10 may be damaged by stress upon separating GaAs substrate 1. Thus, sacrifice layer concave portion 4a is formed as a starting point for reliably internally breaking sacrifice layer 4. Sacrifice layer concave portion 4a may be formed by mechanically providing a "marking" concave portion, grinding by a blade or grinding by a water jet, for example, to provide the breaking starting point to sacrifice layer 4. By filling the gap between solar cell 10 and interposer substrate 24 with sealing resin 22, solar cell 10 is mechanically reinforced, and thus, solar cell 10 is not damaged when sacrifice layer concave portion 4a is formed.

### <Separation of GaAs substrate>

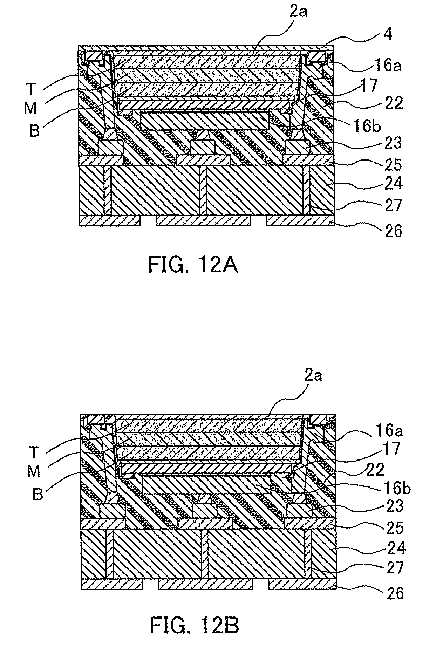

In a process of FIG. 12A, sacrifice layer 4 is internally broken to separate GaAs substrate 1. As an example of a method of internally breaking sacrifice layer 4, various SOI (silicon on insulator) related techniques such as dicing, roller separation, water jet or ultrasonic wave breaking may be used. In this way, GaAs substrate 1 is easily separated.

Further, since the grating constant of GaAs that constitutes substrate 1 is 5.653 angstrom, and the grating constant of AlAs that constitutes sacrifice layer 4 is 5.661 angstrom, both of them approximately matches with each other. Thus, sacrifice layer 4 forms a stable film, and may be stably internally broken.

### <Etching of sacrifice layer>

In a process of FIG. 12B, sacrifice layer 4 that remains in solar cell 10 is removed by wet etching. The wet etching of sacrifice layer 4 may be performed by bring sacrifice layer 4 in contact with a hydrofluoric acid for two to three minutes to be molten and removed. Since solar cell 10 is protected by sealing resin 22, it is possible to prevent solar cell 10 from being damaged by the hydrofluoric acid.

### <Formation of transparent electrode>

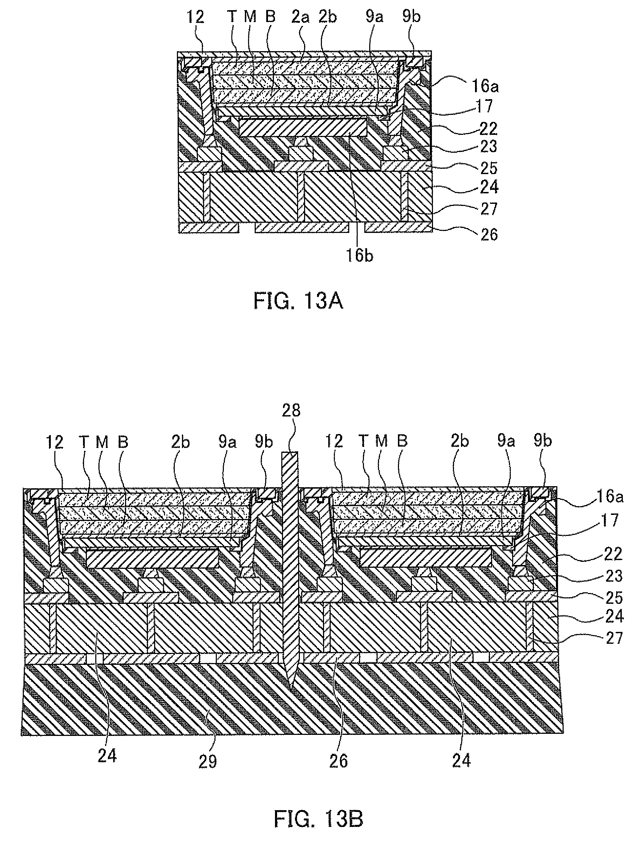

In a process of FIG. 13A, transparent electrode 12 is formed. Transparent electrode 12 constitutes an incident surface of solar light. Transparent electrode 12 may be a ZnO layer, an ITO layer or the like, and may be formed by a sputtering process. Transparent electrode 12 is arranged on the overall upper surface of solar cell 10, and electrically connects upper contact layer 2a and upper contact electrode 9b. By adding Al or Ga to the ZnO layer by 0.1 % by mass or more, it is possible to improve conductivity.

Solar cell 10 obtained in this way does not have an electrode that blocks solar light, on the incidence surface of the solar light. Accordingly, the amount of solar light that is incident on solar cell 10 is increased, and power generation efficiency of solar cell 10 is improved.

### <Individualization>

In a process of FIG. 13B, a solar battery is individualized. A plurality of solar batteries is arranged on interposer substrate 24. First, interposer substrate 24 on which the plurality of solar batteries is arranged is attached to electron sheet 29. Next, using a dicing apparatus that includes dicing blade 28, the solar batteries with interposer substrate 24 are individualized. In the present embodiment, the solar battery is individualized into the size of 500 µm x 500 µm.

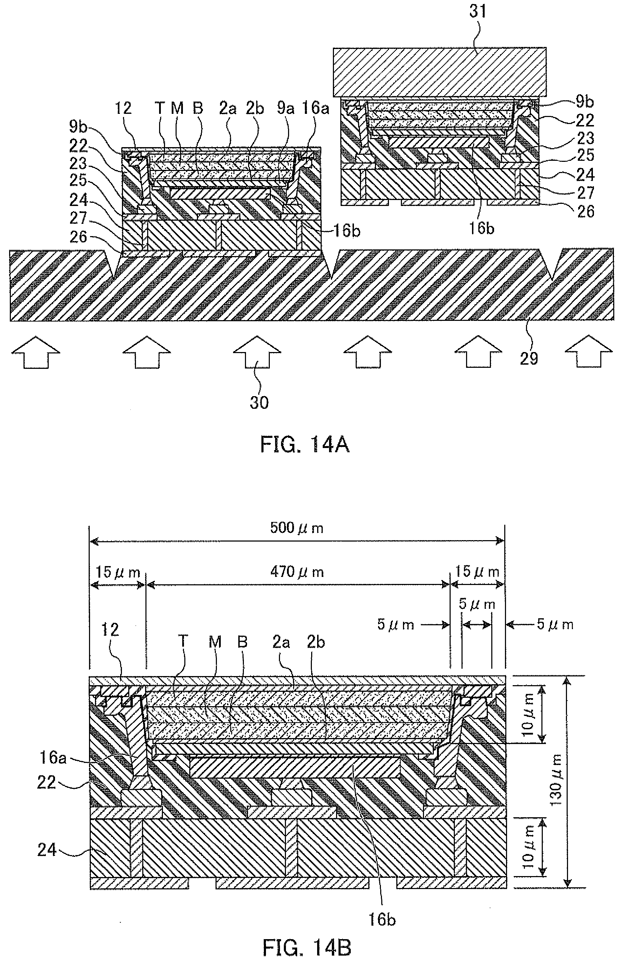

In a process of FIG. 14A, the individualized solar battery is separated from electron sheet 29. First, UV light 30 is irradiated onto electron sheet 29 to decrease adhesiveness of an adhesive material that is present on the surface of electron sheet 29. When the adhesiveness of the adhesive material is reduced, the individualized solar battery is extracted from electron sheet 29 by pickup head 31 of the die bonding apparatus, and is then transferred to a predetermined position.

### <Dimension of solar battery>

FIG. 14B is a diagram illustrating a specific dimension of an individualized multi-junction compound solar battery. Since the cell laminate of solar cell 10 is very thin (10 µm or less), the cell laminate is weak. For this reason, it is necessary to secure mechanical strength by increasing the thickness of interposer substrate 24 to a certain degree, and by filling the gap with sealing resin 22. Thus, the thickness of interposer substrate 24 is set to 100 µm. As a result, the total thickness of the solar battery becomes 130 µm.

The appearance size of the solar battery is 500 µm x 500 µm, and the appearance size of the cell laminate of solar cell 10 is 470 µm x 470 µm. Further, the extension length of side surface electrode 16a is 1 µm. That is, the occupied area of solar cell 10 (the appearance size of the cell laminate of solar cell 10 with respect to the appearance size of the solar battery) is 88%.

Since an electrode other than transparent electrode 12 is not provided on a light receiving surface of solar cell 10, it is possible to use the overall solar light that is irradiated.

In the solar battery shown in FIG. 14B, the appearance size of the cell laminate of solar cell 10 is set to 470 µm x 470 µm, but may be enlarged up to 500 µm x 485 µm. That is, in a case where side surface electrode 16a is arranged only on one side surface among four side surfaces of the cell laminate, it is possible to enlarge the appearance size of the cell laminate up to 500 µm x 485 µm. Here, the occupied area of solar battery 10 is 97%.

The present application claims priority based on Japanese Patent Application No, 2011-113643, filed May 20, 2011, the content of which is incorporated herein by reference.

### Industrial Applicability

The multi-junction compound solar battery of the invention may be applied to a concentrating solar battery used on the Earth in addition to existing usage in space. Further, it is possible to remarkably enhance conversion efficiency of solar light compared with a silicon solar cell in the related art. Thus, the multi-junction compound solar battery of the invention is particularly suitable for a large-scale power generation system in an area with a large amount of daylight.

### Reference Signs List

- 1: GaAs substrate
- 2: Contact layer
- 2a: Upper contact layer
- 2b: Lower contact layer
- 4: Sacrifice layer
- 4a: Sacrifice layer concave portion
- 5: AlGaAs layer
- 6: GaAs layer
- 7: InGaAs layer
- 8: GaAs layer
- 9: Rear surface electrode
- 9a: Lower electrode
- 9b: Upper electrode
- 10: Solar cell
- 12: Transparent electrode
- 15: Surface electrode
- 16a: Side surface electrode
- 16b: Central electrode
- 17: Insulating layer
- 17a: Window of insulating layer
- 18: Resist
- 19: Tunnel layer
- 20: Grid layer
- 21: Buffer layer
- 22: Sealing resin
- 23: Protrusion electrode
- 23a: Stress absorption layer
- 23b: Column portion
- 24: Interposer substrate
- 25: Element-sided electrode
- 26: External extraction electrode
- 27: Through electrode
- 28: Dicing blade
- 29: Electron sheet
- 30: UV irradiation light
- 31: Pickup head
- T: Top cell
- M: Middle cell
- 13: Bottom cell
- C: Cell main body
- T1: GaAs layer
- T2: AlInP layer
- T3: InGaP layer
- T4: InGaP layer
- T5: AlInP layer
- M: 1 AlInP layer
- M2: GaAs layer
- M3: GaAs layer
- M4: InGaP layer
- B6: InP layer
- B7: InGaAs layer
- B8: InGaAs layer
- B9: InP layer
- B10: GaAs layer

## Claims

1. A multi-junction compound solar cell (10) comprising:
a multi-junction cell laminate that includes a top cell (T) and a bottom cell (B);
a transparent electrode (12) that is disposed on a light incident surface of the top cell (T) so as to cover the light incident surface of the top cell; and
a lower electrode (9a) that has an electric potential of the bottom cell (B),
wherein
a side surface electrode (16a) that is disposed on a side surface of the cell laminate with an insulating layer (17) interposed therebetween, the side surface electrode being conducted to the transparent electrode (12),
wherein the side surface electrode (16a) is connected to an upper electrode (9b), wherein the transparent electrode (12) constitutes an incident surface of solar light and electrically connects an upper contact layer (2a) and the upper electrode (9b) wherein the side surface electrode (16a) being extended to the lower electrode (9a), wherein the transparent electrode (12) is provided on an upper surface of the upper contact layer (2a) of the cell laminate, **characterized in that** the upper electrode (12) includes an Au plating film.

2. The multi-junction compound solar cell (10) according to any one of claim 1, wherein:
a non-transparent electrode other than the transparent electrode (12) is not disposed on the light incident surface of the top cell.

3. The multi-junction compound solar cell according to claim 1 or 2, wherein:
the thickness of the cell laminate is 10 µm or less.

4. The multi-junction compound solar cell according to any one of claims 1 to 3, wherein:
the insulating layer (17) is a silicon nitride layer, and the side surface electrode (16a) is made of a metallic conductive material.

5. A multi-junction compound solar battery comprising:
the multi-junction compound solar cell according to any one of claims 1 to 4; and
an external member (24) that is connected to each of the lower electrode (9a) and the side surface electrode (16a),
wherein conductive members that respectively connect the lower electrode (9a) and the side surface electrode (16a) with the external member (24) include a stress absorption layer.

6. The multi-junction compound solar battery according to claim 5, wherein:
the stress absorption layer is made of a metallic material.

7. The multi-junction compound solar battery according to claim 5 or 6, wherein:
the stress absorption layer is formed of conductive paste including a resin component and a conductive metal.

8. A multi-junction compound solar battery comprising:
the multi-junction compound solar cell according to any one of claims 1 to 4; and
an external member (24) that is connected to each of the lower electrode (9a) and the side surface electrode (16a),
wherein connection sections that respectively connect the lower electrode (9a) and the side surface electrode (16a) with the external member (24) are not overlapped with the cell laminate in a pressing direction for connection of the multi-junction compound solar cell with the external member.

9. The multi-junction compound solar battery according to claim 5 or 8, wherein:
the thickness of the cell laminate is smaller than the thickness of the lower electrode (9a).

10. The multi-junction compound solar battery according to claim 9, wherein:
the thickness of the cell laminate is 10 µm or less, and the thickness of the lower electrode (9a) is 10 µm or more.

11. A method for manufacturing the multi-junction compound solar battery according to claim 5, comprising:
pressing and joining the lower electrode and the side surface electrode of the multi-junction compound solar cell, to the external member with a conductive member interposed therebetween,
wherein the shape of a side surface of the conductive member is a tapered shape, and the tapered shape is crushed and deformed by the joining.

12. The method according to claim 11, wherein:
the shape of the side surface of the conductive member is a tapered shape that is inclined at 30° to 60° with respect to a pressing direction for joining the multi-junction compound solar cell and the external member.

13. The method according to claim 11 or 12, wherein:
the thickness of the cell laminate is 10 µm or less, and
the thickness of the conductive member is 20 µm or more, and the thickness of the stress absorption layer after joining is 10 µm or less.

14. The method according to any one of claims 11 to 13, wherein:
the conductive member is formed in the external member.

## Patentansprüche

1. Verbundsolarzelle mit mehreren Anschlüssen (10), umfassend:
ein Zelllaminat mit mehreren Anschlüssen, das eine obere Zelle (T) und eine untere Zelle (B) umfasst;
eine transparente Elektrode (12), die so auf einer Lichteinfallsoberfläche der oberen Zelle (T) angeordnet ist, dass sie die Lichteinfallsoberfläche der oberen Zelle bedeckt; und
eine untere Elektrode (9a), die ein elektrisches Potential der unteren Zelle (B) hat,
wobei
eine Seitenflächenelektrode (16a), die auf einer Seitenfläche des Zelllaminats mit einer dazwischenliegenden Isolierschicht (17) angeordnet ist, wobei die Seitenflächenelektrode zur transparenten Elektrode (12) geleitet wird,
wobei die Seitenflächenelektrode (16a) mit einer oberen Elektrode (9b) verbunden ist, wobei die transparente Elektrode (12) eine Einfallsoberfläche für Solarlicht darstellt und eine obere Kontaktschicht (2a) und die obere Elektrode (9b) elektrisch verbindet, wobei die Seitenflächenelektrode (16a) zur unteren Elektrode (9a) erweitert wird, wobei die transparente Elektrode (12) auf einer oberen Fläche der oberen Kontaktschicht (2a) des Zelllaminats bereitgestellt wird, **gekennzeichnet dadurch, dass**
die obere Elektrode (12) eine Au-Plattierfolie umfasst.

2. Verbundsolarzelle mit mehreren Anschlüssen (10) nach Anspruch 1, wobei:
eine andere nicht transparente Elektrode als die transparente Elektrode (12) nicht auf der Lichteinfallsoberfläche der oberen Zelle angeordnet ist.

3. Verbundsolarzelle mit mehreren Anschlüssen nach Anspruch 1 oder 2, wobei:
die Stärke des Zelllaminats 10 µm oder weniger ist.

4. Verbundsolarzelle mit mehreren Anschlüssen nach Anspruch 1 bis 3, wobei:
die Isolierschicht (17) eine Siliziumnitridschicht ist und die Seitenflächenelektrode (16a) aus einem metallischen leitfähigen Material hergestellt ist.

5. Verbundsolarbatterie mit mehreren Anschlüssen, umfassend:
die Verbundsolarzelle mit mehreren Anschlüssen nach einem der Ansprüche 1 bis 4 und
ein externes Element (24), das mit jeder der unteren Elektroden (9a) und der Seitenflächenelektrode (16a) verbunden ist,
wobei leitfähige Elemente, die die untere Elektrode (9a) und die Seitenflächenelektrode (16a) jeweils mit dem externen Element (24) verbinden, eine Belastungsabsorptionsschicht umfassen.

6. Verbundsolarbatterie mit mehreren Anschlüssen nach Anspruch 5, wobei:
die Belastungsabsorptionsschicht aus einem metallischen Material hergestellt ist.

7. Verbundsolarbatterie mit mehreren Anschlüssen nach Anspruch 5 oder 6, wobei
die Belastungsabsorptionsschicht aus einer leitfähigen Paste gebildet ist, die eine Harzkomponente und ein leitfähiges Metall umfasst.

8. Verbundsolarbatterie mit mehreren Anschlüssen, umfassend:
die Verbundsolarzelle mit mehreren Anschlüssen nach einem der Ansprüche 1 bis 4 und
ein externes Element (24), das mit jeder der unteren Elektroden (9a) und der Seitenflächenelektrode (16a) verbunden ist,
wobei Verbindungsbereiche, die die untere Elektrode (9a) und die Seitenflächenelektrode (16a) jeweils mit dem externen Element (24) verbinden, nicht vom Zellenlaminat in eine Druckrichtung zum Verbinden der Verbundsolarzelle mit mehreren Anschlüssen mit dem externen Element überlagert werden.

9. Verbundsolarbatterie mit mehreren Anschlüssen nach Anspruch 5 oder 8, wobei:
die Stärke des Zelllaminats geringer ist als die Stärke der unteren Elektrode (9a).

10. Verbundsolarbatterie mit mehreren Anschlüssen nach Anspruch 9, wobei:
die Stärke des Zelllaminats 10 µm oder weniger ist und die Stärke der unteren Elektrode (9a) 10 µm oder mehr ist.

11. Verfahren zum Herstellen der Verbundsolarbatterie mit mehreren Anschlüssen nach Anspruch 5, umfassend:
Drücken und Verbinden der unteren Elektrode und der Seitenflächenelektrode der Verbundsolarzelle mit mehreren Anschlüssen mit dem externen Element mit einem dazwischenliegenden leitfähigen Element,
wobei die Form einer Seitenfläche des leitfähigen Elements eine kegelförmige Form ist und die kegelförmige Form durch das Verbinden zerdrückt und verformt wird.

12. Verfahren nach Anspruch 11, wobei:
die Form der Seitenfläche des leitfähigen Elements eine kegelförmige Form ist, die zu 30 ° bis 60 ° in Bezug auf eine Druckrichtung zum Verbinden der Verbundsolarzelle mit mehreren Anschlüssen und dem externen Element geneigt ist.

13. Verfahren nach Anspruch 11 oder 12, wobei:
die Stärke des Zelllaminats 10 µm oder weniger ist und
die Stärke des leitfähigen Elements 20 µm oder mehr ist und die Stärke der Belastungsabsorptionsschicht nach dem Verbinden 10 µm oder weniger ist.

14. Verfahren nach einem der Ansprüche 11 bis 13, wobei:
das leitfähige Element im externen Element gebildet wird.

## Revendications

1. Cellule photovoltaïque composée multi-jonction (10) comprenant :
un stratifié de cellules multi-jonction présentant une cellule supérieure (T) et une cellule inférieure (B),
une électrode transparente (12) disposée sur une surface d'incidence de lumière de la cellule supérieure (T) de manière à couvrir la surface d'incidence de lumière de la cellule supérieure, et
une électrode inférieure (9a) ayant un potentiel électrique de la cellule inférieure (B),
dans laquelle :
une électrode de surface latérale (16a) est disposée sur une surface latérale du stratifié de cellules, une couche isolante (17) étant intercalée entre elles, l'électrode de surface latérale étant conduite jusqu'à l'électrode transparente (12),
l'électrode de surface latérale (16a) est reliée à une électrode supérieure (9b), l'électrode transparente (12) constituant une surface d'incidence de la lumière solaire et connectant électriquement une couche de contact supérieure (2a) et l'électrode supérieure (9b), l'électrode de surface latérale (16a) s'étendant jusqu'à l'électrode inférieure (9a), l'électrode transparente (12) étant située sur une surface supérieure de la couche de contact supérieure (2a) du stratifié de cellules,
**caractérisée en ce que** l'électrode supérieure (12) présente une pellicule de placage en Au.

2. Cellule photovoltaïque composée multi-jonction (10) selon la revendication 1, dans laquelle :
une électrode non transparente autre que l'électrode transparente (12) n'est pas disposée sur la surface d'incidence de lumière de la cellule supérieure.

3. Cellule photovoltaïque composée multi-jonction selon la revendication 1 ou 2, dans laquelle :
l'épaisseur du stratifié de cellules est de 10 µm ou moins.

4. Cellule photovoltaïque composée multi-jonction selon l'une quelconque des revendications 1 à 3, dans laquelle :
la couche isolante (17) est une couche de nitrure de silicium, et l'électrode de surface latérale (16a) se compose d'un matériau métallique conducteur.

5. Batterie photovoltaïque composée multi-jonction comprenant :
la cellule photovoltaïque composée multi-jonction selon l'une quelconque des revendications 1 à 4, et
un élément externe (24) qui est relié à la fois à l'électrode inférieure (9a) et à l'électrode de surface latérale (16a) ;
les éléments conducteurs qui relient respectivement l'électrode inférieure (9a) et l'électrode de surface latérale (16a) à l'élément externe (24) comportant une couche d'absorption des contraintes.

6. Batterie photovoltaïque composée multi-jonction selon la revendication 5, dans laquelle :
la couche d'absorption des contraintes se compose d'un matériau métallique.

7. Batterie photovoltaïque composée multi-jonction selon la revendication 5 ou 6, dans laquelle :
la couche d'absorption des contraintes est constituée d'une pâte conductrice comprenant un composant de résine et un métal conducteur.

8. Batterie photovoltaïque composée multi-jonction comprenant :
la cellule photovoltaïque composée multi-jonction selon l'une quelconque des revendications 1 à 4, et
un élément externe (24) qui est relié à la fois à l'électrode inférieure (9a) et à l'électrode de surface latérale (16a) ;
les parties de connexion qui relient respectivement l'électrode inférieure (9a) et l'électrode de surface latérale (16a) à l'élément externe (24) ne présentant pas de chevauchement avec le stratifié de cellules dans une direction de pression permettant de la connexion de la cellule photovoltaïque composée multi-jonction avec l'élément externe.

9. Batterie photovoltaïque multi-jonction selon la revendication 5 ou 8, dans laquelle :
l'épaisseur du stratifié de cellules est inférieure à l'épaisseur de l'électrode inférieure (9a).

10. Batterie photovoltaïque composée multi-jonction selon la revendication 9, dans laquelle :
l'épaisseur du stratifié de cellules est de 10 µm ou moins et l'épaisseur de l'électrode inférieure (9a) est de 10 µm ou plus.

11. Procédé de fabrication de la batterie photovoltaïque composée multi-jonction selon la revendication 5, comprenant les étapes consistant à :
presser et joindre l'électrode inférieure et l'électrode de surface latérale de la cellule photovoltaïque composée multi-jonction à l'élément externe, un élément conducteur étant interposé entre eux ;
la forme de la surface latérale de l'élément conducteur étant une forme effilée, la forme effilée étant écrasée et déformée par le jointement.

12. Procédé selon la revendication 11, dans lequel :
la forme de la surface latérale de l'élément conducteur est une forme effilée inclinée de 30° à 60° par rapport à la direction de pression suivie pour joindre la cellule photovoltaïque composée multi-jonction à l'élément externe.

13. Procédé selon la revendication 11 ou 12, dans lequel :
l'épaisseur du stratifié de cellules est de 10 µm ou moins, et
l'épaisseur de l'élément conducteur est de 20 µm ou plus, et l'épaisseur de la couche d'absorption des contraintes après le jointement est de 10 µm ou moins.

14. Procédé selon l'une quelconque des revendications 11 à 13, dans lequel :
l'élément conducteur est constitué dans l'élément externe.
